# EUROPÄISCHE PATENTSCHRIFT

(11) **EP 3 143 697 B1**
(45) Veröffentlichungstag und Bekanntmachung des Hinweises auf die Patenterteilung: **08.09.2021**
(21) Anmeldenummer: 15721729.0
(22) Anmeldetag: 13.05.2015
(51) Int. Cl.: H03M 3/00

(54) **SCHNELLE STROMREDUZIERTE DIGITALISIERUNG, AUFBEREITUNG UND FILTERUNG VON ANALOG-SIGNALEN EINES SENSORS ODER DETEKTORS**
FAST REDUCED-CURRENT DIGITIZATION, CONDITIONING AND FILTERING OF ANALOGUE SIGNALS FROM A SENSOR OR DETECTOR
NUMÉRISATION RAPIDE À CONSOMMATION DE COURANT RÉDUITE, TRAITEMENT ET FILTRAGE DE SIGNAUX ANALOGIQUES D'UN CAPTEUR OU DÉTECTEUR

(30) Priorität: 15.05.2014 EP 14168470; 17.02.2015 EP 15155410; 01.04.2015 EP 15162245
(43) Veröffentlichungstag der Anmeldung: 22.03.2017
(73) Patentinhaber: Elmos Semiconductor SE, 44227 Dortmund (DE)
(72) Erfinder: SUNTKEN, Artur Wilhelm, Tiegerpoort 0056 (ZA)
(74) Vertreter: dompatent von Kreisler Selting Werner - Partnerschaft von Patent- und Rechtsanwälten mbB
(86) Internationale Anmeldenummer: PCT/EP2015/060571
(87) Internationale Veröffentlichungsnummer: WO 2015/173293

(56) Entgegenhaltungen:
- DE-A1-102004 030 812
- US-A1- 2009 079 607
- US-A1- 2009 079 607
- US-B1- 6 535 153
- US-B1- 7 474 247
- US-B1- 7 474 247
- SHUN YAO ET AL: "High Dynamic Range adaptive -based Focal Plane Array architecture", SIGNALS, SYSTEMS AND COMPUTERS (ASILOMAR), 2011 CONFERENCE RECORD OF THE FORTY FIFTH ASILOMAR CONFERENCE ON, IEEE, 6. November 2011 (2011-11-06), Seiten 505-510, XP032172156, DOI: 10.1109/ACSSC.2011.6190052 ISBN: 978-1-4673-0321-7
- SHUN YAO ET AL: "High Dynamic Range adaptive -based Focal Plane Array architecture", SIGNALS, SYSTEMS AND COMPUTERS (ASILOMAR), 2011 CONFERENCE RECORD OF THE FORTY FIFTH ASILOMAR CONFERENCE ON, IEEE, 6 November 2011 (2011-11-06), pages 505-510, XP032172156, DOI: 10.1109/ACSSC.2011.6190052 ISBN: 978-1-4673-0321-7

## Beschreibung

Die Erfindung betrifft eine Vorrichtung und ein Verfahren zur schnellen stromreduzierten Digitalsierung, Aufbereitung und Filterung von Signalen eines Sensors oder Detektors, insbesondere eines Thermopile-Sensors, der eine Thermopile-Pixelzeile oder ein Thermopile-Pixelarray aufweisen kann.

Thermopiles werten die Infrarotstrahlung im µm Bereich aus. Diese Wellenlänge entspricht der Wärmestrahlung, die Körper und insbesondere auch der Mensch als Temperaturstrahlung bei üblichen Temperauren an ihre Umgebung abgeben. Es ist ein Ziel vieler Anwendungen beispielsweise mit Hilfe von Infrarotoptiken in Kombination mit Arrays solcher Thermopiles einfache Wärmebilder zu erzeugen.

Zum Auslesen der Thermopile-Pixel müssen sehr geringe Nutzspannungen ausgewertet werden. Naturgemäß rauschen Verstärker aus verschiedensten Gründen. Dieses Rauschen und auch Störungen, die im System erzeugt werden sowie Störungen, die über andere Wege eingestrahlt werden, müssen bei der Auswertung der Thermopile-Informationen zugunsten des Nutzsignals unterdrückt werden.

Die effektive Rauschspannung nimmt mit der Bandbreite der Signalverarbeitung zu. Deshalb ist man bestrebt, die Bandbreite so gering wie möglich zu halten.

Aus dem Stand der Technik sind Systeme bekannt, bei denen die Thermopile-Pixel mit Hilfe von programmierbaren Verstärkern in Kombination mit Tiefpassfiltern zur Rauschunterdrückung ausgelesen werden.

Hierbei ergibt sich das Problem, dass mit jedem Zeilenwechsel und/oder Wechsel eines Thermopile-Pixels innerhalb eines Thermopile-Arrays durch die Tiefpasscharakteristik die Werte des zuvor ausgelesenen Thermopile-Pixels in dem besagten Tiefpass noch gespeichert sind, was sich als Übersprechen von einer Zeile zur nächsten und/oder ein Übersprechen von einem Pixel zum nächsten bemerkbar macht. Während der Grad der Veränderung des Pixel-Spannungssignals während eines Ausleseintervalls vergleichsweise gering ist, können die Veränderungen der Spannungssignale von Pixel zu Pixel durchaus spürbar sein. Beim Umschalten von einem Pixel auf das nächste Thermopile-Pixel ist die Auslese-Hardware also am Eingang höherfrequenten Veränderungen ausgesetzt. Arbeitet die Auslese-Hardware also nicht schnell genug, so muss eine gewisse Zeit abgewartet werden, bis das nächste Pixel ausgelesen ist. Man könnte hier mit höherfrequent arbeitenden Hardware-Schaltungen arbeiten, was aber aus anderen Gründen, insbesondere hinsichtlich eines erhöhten schaltungstechnischen Aufwandes, von Nachteil ist.

Das zuvor beschriebene Problem stellt sich nicht nur bei Thermopile-Sensoren sondern ebenso bei anderen IR-Strahlungssensoren oder für andere Strahlung sensitive Detektoren bzw. Sensoren.

US-B-7474247 beschreibt ein Verfahren zur Wandlung eines Analog-Signals in ein Mehrbit-Digital-Signal bei einem "Implantable Medical Device" (IMD), wobei ein Regler dann, wenn der Analog-Digital-Konverter wegen z.B. EMV-Störungen überlastet ist, schneller arbeitet als in dem Fall, in dem der Analog-Digital-Konverter nicht überlastet ist.

Aus US-B-6535153 ist ein adaptiver Sigma-Delta-Modulator bekannt, der in zwei Betriebsmodi, nämlich bei zwei unterschiedlichen Verarbeitungsgeschwindigkeiten, betrieben werden kann.

Es ist daher die Aufgabe der Erfindung, ein schnelles Auslesen eines Sensor- oder Detektor-Pixel, insbesondere eines Thermopile-Pixel zu ermöglichen, ohne dass es zu einem Übersprechen durch die beschriebene Tiefpassproblematik kommt und gleichzeitig die Bandbreite minimal gehalten werden kann.

Zur Lösung dieser Aufgabe wird mit der Erfindung ein Verfahren zur Wandlung eines Analog-Signals (TP[i]), wie z.B. eines Spannungs-Auslesesignals eines Thermopile-Pixels, in ein Mehrbit-Digital-Signal (SB) vorgeschlagen, wobei das Verfahren die Schritte gemäß Anspruch 1 umfasst.

Ferner wird zur Lösung der Aufgabe eine Vorrichtung zur Wandlung eines Analog-Signals (TP[i]), wie z.B. eines Spannungs-Auslesesignals eines Thermopile-Pixels oder eines Pixels eines anderen strahlungsempfindlichen Detektors, in ein Mehrbit-Digital-Signal (SB) vorgeschlagen, wobei die Vorrichtung versehen ist mit den Merkmalen des Anspruchs 5.

Einzelne Ausgestaltungen der Erfindung sind Gegenstand der Unteransprüche.

Nach der Erfindung wird ein Delta-Sigma-Wandler eingesetzt, der mit einem Mehrbit-Regler zusammenarbeitet, welcher wahlweise in einem ersten oder in einem zweiten Betriebsmodus arbeitet. Charakteristisch für den Unterschied dieser beiden Betriebsmodi ist, dass der Regler in seinem ersten Betriebsmodus Soll-/Istwert-Abweichungen schnell ausregelt als in seinem zweiten Betriebsmodus. Zu Beginn eines Ausleseintervalls, wenn also am Eingang des Delta-Sigma-Wandlers das Analog-Signal des nächsten auszulesenden Thermopile-Pixels ansteht, wird der Regler im ersten Betriebsmodus betrieben. Dadurch findet der Regler relativ schnell seinen Arbeitspunkt, so dass er anschließend, wenn er im zweiten Betriebsmodus arbeitet, relativ schnell noch gegebene Regelabweichungen ausregelt. Die Ausregelung dieser Regelabweichungen ist langsamer als dann, wenn der Regler zu diesem Zeitpunkt weiterhin noch in seinem ersten Betriebsmodus arbeiten würde. Dafür aber ist die Ausregelung von Regelabweichungen im zweiten Betriebsmodus wesentlich präziser als im ersten Betriebsmodus.

Auf diese Weise kann also der Regler jeweils optimal betrieben werden, und zwar zu Beginn eines Ausleseintervalls kann er schnell arbeiten (mit eingeschränkter Genauigkeit, was die Ausregelung von Regelabweichungen betrifft), während er im Anschluss daran für den Rest des Ausleseintervalls langsamer arbeitet (dafür aber auch präziser Regelabweichungen ausregelt und damit eine genauere Umsetzung des Analog-Signals in ein digitales Mehrbit-Signal ermöglicht).

Erfindungsgemäß weist also der Delta-Sigma-Wandler effektiv keine Bandbegrenzung auf, was bei bisherigen, für die Auslesung von Thermopile-Pixeln verwendeten Hardware-Schaltungen jeweils gegeben war und zu den oben genannten Problemen führte.

In weiterer vorteilhafter Ausgestaltung der Erfindung kann vorgesehen sein, dass das Tiefpassfilter mindestens einen Kondensator aufweist, der nach dem Ende eines Ausleseintervalls und/oder zu Beginn der Anfangsphase des nächsten Ausleseintervalls entladen wird. Es ist vorgesehen, dass dem Tiefpassfilter ein Analog-Signal-Verstärker vorgeschaltet ist und dass das Differenzsignal aus dem Analog-Signal und dem Rückführsignal im Frequenzbereich von einem Ausgangsfrequenzband in ein Zielfrequenzband angehoben und in zwei Absenkstufen wieder bis in das Ausgangsfrequenzband abgesenkt wird, wobei die erste Absenkstufe nach dem Verstärker und vor dem Tiefpassfilter und die zweite Frequenzbereich-Absenkstufe nach dem Quantisierer und vor dem Regler durch jeweiliges Heruntermischen erfolgt. Durch die Transformation in einen höheren Frequenzbereich, das dann erfolgende Verstärken des Analog-Signals, um danach dann wieder eine Rücktransformation des Frequenzbereichs durchzuführen, wird erreicht, dass Rauscheinflüsse durch den Analog-Signal-Verstärker reduziert werden.

Schließlich kann bei einer vorteilhaften Ausgestaltung der Erfindung noch vorgesehen sein, dass ein Thermopile-Pixelarray bereitgestellt wird, das mehrere Zeilen von Pixeln mit jeweils mehreren Pixeln aufweist, und dass pro Zeile deren jeweilige Pixel-Spannungsauslesesignale gleichzeitig ausgelesen werden, und zwar jeweils gemäß den Verfahrensschritten nach einem der vorhergehenden Ansprüche, und dass sukzessive von Zeile zu Zeile umgeschaltet wird, um das Thermopile-Pixelarray auszulesen.

Die erfindungsgemäße Lösung besteht also in der Unterdrückung des Rausch- und Störspektrums, ohne den oben beschriebenen Memory-Effekt. Dies gelingt mit dem Verfahren gemäß Anspruch 1.

Im Folgenden wird die Erfindung anhand der beigefügten Zeichnungen noch weiter erläutert, ohne dass die Erfindung auf das in den Zeichnungen dargestellte Beispiel beschränkt ist. Es zeigen:
- Fig. 1: die Struktur eines erfindungsgemäßen Delta-Sigma-Wandlers für die Auswertung eines Thermopile-Arrays,
- Fig. 2: das Taktschema bezogen auf den Systemtakt CK und einzelne Signale des Delta-Sigma-Wandlers nach Fig. 1,
- Fig. 3: ein Taktschema bezogen auf den digitalen Systemtakt CK für das schnelle Chopper-Signal B und das langsame Chopper-Signal A des Delta-Sigma-Wandlers nach Fig. 1,
- Fig. 4: die Offset-Kompensation im Transimpedanzverstärker TV und
- Fig. 5: die Struktur eines alternativ ausgebildeten Delta-Sigma-Wandlers für die Auswertung eines Thermopile-Arrays.

Das Spannungssignal TP[n] bezeichnet das auszulesende Analog-Spannungssignal des n-ten an den erfindungsgemäßen Delta-Sigma-Wandler für die Auswertung eines Thermopile-Arrays angeschlossenen Thermopile-Pixels. Die sukzessive Zuführung derartiger Pixel-Signale erfolgt über den Multiplexer AMUX. Das Spannungssignal TP[n] bildet zusammen mit dem später erläuterten Rückkoppelsignal S8 das Differenz-Eingangssignal S0 (siehe bei SUB). Für die digitale Signalverarbeitung ist es von Vorteil, im Weiteren mit Differenz-Signalen zu arbeiten. Der Wert des Differenz-Eingangssignals S0 ergibt sich als die Differenz zwischen dem Spannungssignal TP[n] und dem Rückkoppelsignal S8. Das Eingangssignal S0 wird auf einen ersten Multiplizierer M1 gegeben. Dieser erste Multiplizierter M1 multipliziert das Eingangssignal S0 mit einem langsamen Chopper-Signal A, was letztendlich einer Transformation der Frequenzen des Analog-Spannungssignals TP[n] in einem höheren Frequenzbereich (auch als "Hochmischen" bezeichnet) gleichkommt. Das langsame (outer loop) Chopper-Signal A wechselt typischerweise bei dem Wechsel einer Thermopile-Zeile und bei der Hälfte der Messperiode seinen logischen Wert. Dieser kann hier vorzugsweise die Werte -1 und +1 annehmen. Da das langsame Chopper-Signal A somit typischerweise ein digitales Signal ist, ist dieser erste Multiplizierer M1 vorzugsweise als einfacher Doppelumschalter realisiert, der mit Hilfe des digitalen langsamen Chopper-Signals A umgeschaltet wird. Die Bewertung der logischen Zustände des langsamen Chopper-Signals A mit -1 und 1 führt in Verbindung mit der Folge der Werte des Eingangssignals S0 zum ersten Signal S1, was sich insoweit aus der Multiplikation von S0 mit dem ersten Multiplizierer M1 ergibt.

Das erste Signal S1 wird sodann auf einen zweiten Multiplizierer M2 gegeben. Dieser zweite Multiplizierter M2 multipliziert das erste Signal S1 mit einem zweiten, schnellen Chopper-Signal B, was ein zweites Signal S2 ergibt. Das zweite schnelle Chopper-Signal B hat eine höhere Frequenz als das langsame Chopper-Signal A. Auch dieses zweite schnelle Chopper-Signal B kann vorzugsweise die Werte -1 und +1 hinsichtlich seiner Wirkung auf das erste Signal S1 annehmen. Das schnelle Chopper-Signal B ist somit ebenfalls typischerweise ein digitales Signal. Daher kann auch dieser zweite Multiplizierer M2 vorzugsweise ebenfalls als einfacher Doppelumschalter realisiert und mit Hilfe des digitalen schnellen Chopper-Signals B umgeschaltet werden. Die Bewertung der logischen Zustände des schnellen Chopper-Signals B mit -1 und 1 ergibt sich wieder aus der Folge eines Zustandswechsels des schnellen Chopper-Signals B für den Wert des zweiten Signals. Es ergibt sich das zweite Signal S2, das wiederum als im Frequenzbereich transformiertes erstes Signal S1 ("Hochmischen") aufgefasst werden kann.

Ein Transimpedanzverstärker TV ist über das zweite Signal S2 mit dem Ausgang des zweiten Multiplizierers M2 verbunden und verstärkt das somit inzwischen doppelt-modulierte (englisch: double chopped oder nested chopped) differentielle Eingangssignal S0, wobei ein drittes Signal S3 entsteht, das aus zwei zueinander differentiellen Stromsignalen besteht.

Durch das Hochmischen, d.h. "Choppen2 des Signals S0 wird das 1/f-Rauschverhalten des Verstärkers TV vorteilhaft genutzt, was aber an sich bekannt ist. Ein dritter Multiplizierer M3 multipliziert das dritte Signal S3 mit dem schnellen Chopper-Signal B. Alternativ könnte auch mit einem invertierten bzw. negativen schnellen Chopper-Signal B gearbeitet werden, wobei im ersten Fall ausgenutzt wird, dass eine doppelte Vertauschung den Ursprungszustand wieder herstellt und im zweiten Fall eine Rückvertauschung die gleiche Wirkung entfaltet. Hierdurch wird das Signal S3 herunter gemischt; es entsteht das vierte Signal S4.

Der Ausgang des dritten Multiplizierers M3 lädt über das vierte Signal S4 die differentielle Integrationskapazität bestehend aus der ersten Einzelkapazität C1 und der zweiten Einzelkapazität C2. In dieser differentiellen Integrationskapazität C1, C2 wird der Strom aus dem Transimpedanzverstärker TV aufintegriert. Das vierte Signal S4 stellt daher bevorzugt die Integration des dritten Signals S3 dar.

Ein Komparator CMP ist über das vierte Signal S4 mit dem Ausgang des dritten Multiplizierers M3 und der differentiellen Integrationskapazität C1, C2 verbunden. Der Komparator CMP wandelt das vierte Signal S4 nun in einen Ein-Bit-Datenstrom um. Den Ausgang des Komparators CMP, der diesen Ein-Bit-Datenstrom liefert, bildet das fünfte Signal S5, das nun im Gegensatz zu den vorhergehenden Signalen S1 bis S4 nicht mehr differentiell ist.

Dieses fünfte Signal S5 wird nun vom Ausgang des Komparators CMP an den Eingang eines vierten Multiplizierers M4 geleitet. Der vierte Multiplizierer M4 multipliziert das fünfte Signal S5 mit dem besagten langsamen Chopper-Signal A. Um hier den Effekt der Multiplikation im ersten Multiplizierer M1 zu neutralisieren, wird das Vorzeichen von des langsamen Chopper-Signals A negiert bzw. im Falle eines digitalen langsamen Chopper-Signals A dessen logischer Wert invertiert. Damit ist das fünfte Signal S5 in den Frequenzbereich des Signals S0 zurücktransformiert. Da sowohl das fünfte Signal S5 als auch das langsame Chopper-Signal A typischerweise digitale binäre Signale sind, ist die einfachste Form der Realisierung des vierten Multiplexers M4 die eines EXOR-Gatters. Das Ergebnis dieser Multiplikation im vierten Multiplizierer M4 und damit dessen Ausgang stellt das sechste Signal S6 dar.

Der nachfolgende Regler ADCFB, der das sechste Signal S6 empfängt, hat zwei Betriebsmodi. In einem ersten Betriebsmodus wird der folgende Digital-zu-Analog-Konverter DAC schnell in die Nähe des Arbeitspunktes gebracht, in dem andern Modus führt der Regler ADCFB eine Differentiation und eine Integration durch, wodurch der Regelkreis die Charakteristik eines PID-Reglers erhält und damit "langsamer" arbeitet. Der Fachmann sei hinsichtlich der Konfiguration und Auslegung der Schleifenfilter für PID Regler auf die regelungstechnische Fachliteratur verwiesen. Der Regler ADCFB wandelt darüber hinaus das eingehende Ein-Bit-Signal, also das sechste Signal S6, in einen Datenbus mit sechs Bit, nämlich in das siebte Signal SB um.

Den Ausgang des Reglers ADCFB bildet das siebte Signal SB. Über dieses siebte Signal SB ist der Regler ADCFB sowohl mit einem digitalen Ausgangsfilter DF, als auch mit einem Digital-zu-Analog-Konverter DAC verbunden. Das digitale Ausgangsfilter DF wandelt nochmals die Busbreite von 6-Bit, des siebten Signals SB, in die Zielbusbreite des Ausgangssignals Out, wobei dieses Ausgangssignal Out gleichzeitig auch das Ausgangssignal des digitalen Ausgangsfilters DF ist.

Der Digital-zu-Analog-Konverter DAC wandelt das siebte Signal SB in das analoge Rückkoppelsignal S8, das schließlich als Differenzsignal mit dem Spannungssignal TP[n] des n-ten an den erfindungsgemäßen Delta-Sigma ADC für die Auswertung eines Thermopile-Arrays angeschlossenen Thermopiles das Eingangssignal S0 bildet. Damit wird der Regelkreis geschlossen. Die Logikschaltung in ADCFB stellt dabei sicher, dass der Regelkreis stabil ist.

Wie bereits dargestellt, ist die Verwendung eines Chopper-Ansatzes bei der Realisierung eines Delta-Sigma-ADCs nicht neu. Ziel der Multiplikationen im ersten bis vierten Multiplizierer M1, M2, M3, M4 ist es, die jeweils folgenden Operationen, hier sind es die Transimpedanzverstärkung im Transimpedanzverstärker TV, die Integration in dem differentiellen Kondensator C1,C2 und die Bewertung im Komparator CMP, in einem Frequenzbereich durchzuführen, in dem das Rausch- und/oder Störspektrum weniger ausgeprägt ist und damit die Wandelqualität zu steigern. Durch zwei Multiplikationen im ersten Multiplizierer M1 und zweiten Multiplizierer M2 erfolgt quasi eine Hintransformation des Nutzsignals von den Frequenzen des Eingangssignals S0 hin zu höheren Frequenzen und durch die zwei Multiplikationen im dritten Multiplizierer M3 und vierten Multiplizierer M4 die entsprechende Rücktransformation. Der erste Multiplizierer M1 und der vierte Multiplizierer M4 bilden daher ein erstes Multiplizierer-Paar und der zweite Multiplizierer M2 und der dritte Multiplizierer M3 ein zweites Multipliziererpaar. Jedes Paar besteht somit aus einem vorausgehenden Multiplizierer zur Hinauf-Transformation zu einer höheren Frequenz und einem folgenden Multiplizierer zur Zurück-Transformation zur Ursprungsfrequenz. Das zweite Multiplizierer-Paar umfasst dabei wie eine Klammer die Transimpedanzverstärkerstufe. Die Frequenz des schnellen Chopper-Signals B wird daher entsprechend dem Rauschspektrum dieser Stufe gewählt. Das erste Multiplizierer Paar umfasst wie eine Klammer neben dem zweiten Multiplizierer-Paar und den von diesem umfassten Transimpedanzverstärker TV zusätzlich noch die differentielle Integrationskapazität C1, C2 und den Komparator CMP. Die erste Frequenz des zugehörigen Steuersignals des ersten Multiplizierer-Paars, die des langsamen Chopper-Signals A. Die erste Frequenz des langsamen Chopper-Signals A orientiert sich dabei an der Zeilenfrequenz, mit der die Thermopilezeilen ausgelesen werden. Der besondere Vorteil der hier dargestellten Lösung ist somit, dass das Choppen den ganzen Quantisierer umfasst und die Rücktransformation durch die vierte Multiplikation im vierten Multiplizierer M4 erst hinter dem Komparator CMP erfolgt. Dabei dient die Tiefpasscharakteristik der Integrationsstufe, die im Wesentlichen durch die differentielle Integrationskapazität C1,C2 im Zusammenspiel mit dem Ausgangswiderstand des Transimpedanzverstärkers TV verursacht wird, als Dezimationsfilter für das zweite Multiplizierer-Paar M2, M3. Je höher die zweite Frequenz des Chopper-Signals B, desto besser wird dessen Frequenz nach der Rücktransformation im dritten Multiplizierer somit unterdrückt. Dessen Frequenz nehmen aber vor allem die besagten Störungen an, die somit aus dem Signalpfad wieder entfernt werden. Das Choppen, d.h. die Hin- und Rücktransformationen durch die besagten Multiplizierer-Paare verringert also das Rauschen und die Offsets im sechsten Signal S6.

Hauptunterschied gegenüber dem Stand der Technik ist die Durchführung der ersten Multiplikation im ersten Multiplizierer M1 direkt am Eingang und die Durchführung der letzten Multiplikation im vierten Multiplizierer M4 hinter dem Quantisierer, d.h. dem Komparator CMP.

Sowohl der notwendige Integrator, als auch der Komparator CMP müssen, um eine hohe Genauigkeit erreichen zu können, langsamer ausgelegt werden. Es ist daher von Vorteil, dass das langsame Chopper-Signal A eine niedrigere erste Frequenz als die Grenzfrequenz des Tiefpasses des differentiellen Integrationskondensators C1, C2 in Kombination mit dem differentiellen Ausgangsinnenwiderstand des Transimpedanzverstärkers TV hat und die Grenzfrequenz dieses Tiefpasses wiederum niedriger ist als die zweite Frequenz des schnellen Chopper-Signals B.

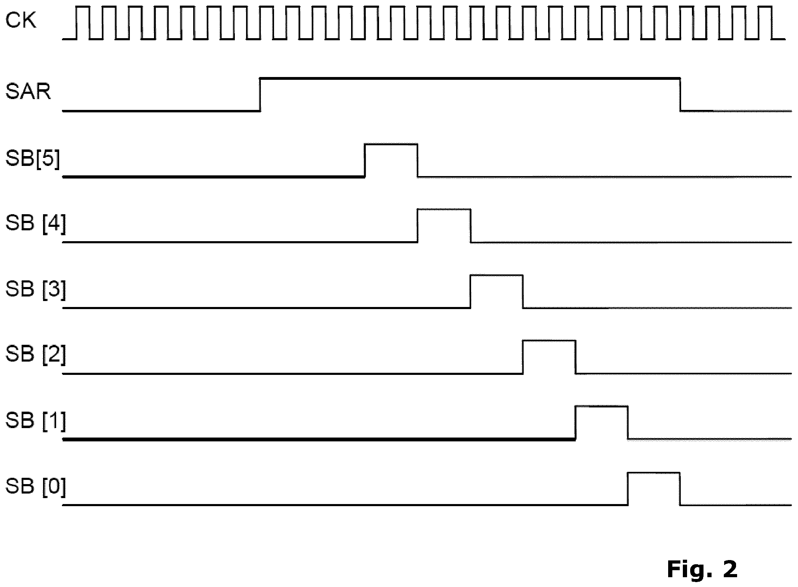

Wird eine Zeile oder ein Thermopile-Pixel gewechselt, so muss der erfindungsgemäße Delta-Sigma-Wandler sehr schnell einen geeigneten Arbeitspunkt finden. Zu diesem Zweck schaltet der Regler ADCFB in einen anderen Betriebsmodus um. Dieser Modus wird typischerweise nur für eine kurze Zeit eingenommen. Daher kann das langsame Chopper-Signal A in dieser Zeit als statisch angenommen werden. Der Modus ist in Fig. 2 durch das Aktivieren eines beispielhaften internen Signals SAR gekennzeichnet.

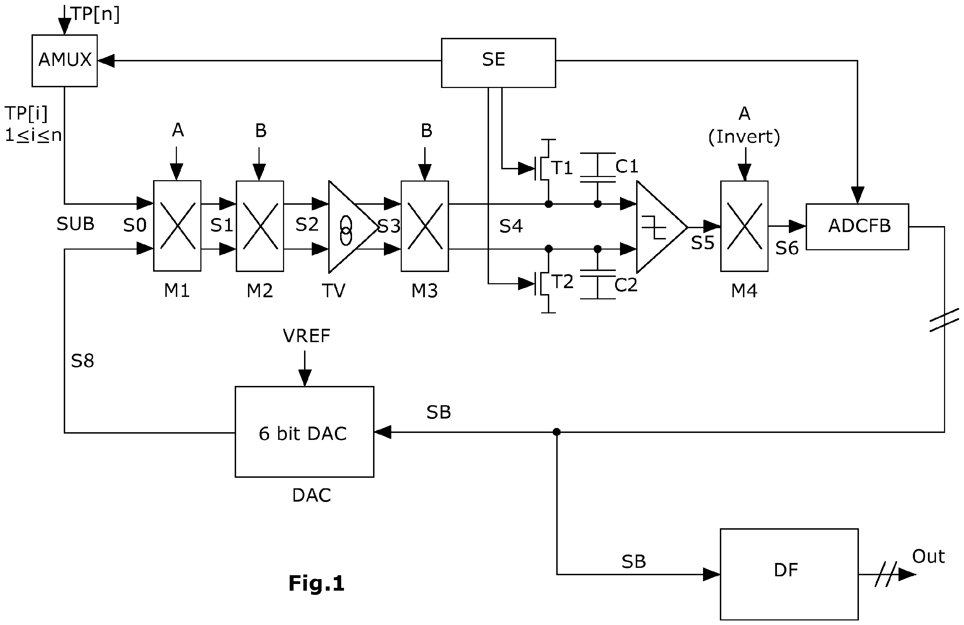

Es wird anschließend wie folgt verfahren. Zuerst wird das MSB des Digital-zu-Analog-Konverters DAC über die entsprechende Mehrbit-Leitung, auf der das siebte Signal SB ansteht, gesetzt. Wird hierdurch der Wert des sechsten Signals S6, welches ein 1 Bit-Signal ist, nicht geflippt, d.h. nicht verändert, so wird das MSB beibehalten. Anderenfalls wird es wieder gelöscht. Danach wird das nächste weniger wertige Bit des siebten Signals SB gesetzt usw. bis das letzte Bit, das LSB bewertet wurde. Diese Startwertermittlung ist schnell und weniger präzise. Daher wird nach deren Abschluss auf die bereits erwähnte PID Filterung (langsamerer Betriebsmodus) umgeschaltet, wobei der ermittelte Wert des siebten Signals SB den Startwert für den Regler ADCFB bildet. Ferner werden zweckmäßigerweise auch die Integrationskondensatoren C1, C2 des Tiefpassfilters zu Beginn eines Ausleseintervalls entladen. Diese Entladungssteuerung sowie die Umschaltung zwischen den Betriebsmodi des Reglers ADCFB und die Zeile- bzw. Spaltenumschaltung des Thermopile-Pixelarrays über den AMUX übernimmt die zentrale Steuereinheit SE (siehe Fig. 1).

Wie in Fig. 1 gezeigt, steuert die Steuereinheit zwei Transistoren T1, T2 an, was für eine Entladung beider Kondensatoren C1, C2 sorgt. Dieser Entladungsvorgang erfolgt vor dem eigentlichen Auslesevorgang des nächsten Thermopile-Pixels.

Die Fig. 2 zeigt darüber noch den Systemtakt CK, was die Schnelligkeit der Arbeitspunktfindung mit dieser Methode zum Ausdruck bringt. Würde der Arbeitspunkt nicht auf diese Weise eingestellt, so wäre die Schaltung den Anforderungen nicht gewachsen und zu langsam. Nach der Einstellung des Arbeitspunktes arbeitet der Delta-Sigma-Wandler im besagten PID-Modus und ist dann im Vergleich zur vorherigen, zu Beginn eines neuen Ausleseintervalls erfolgten Arbeitspunktsuche langsamer aber dafür präziser.

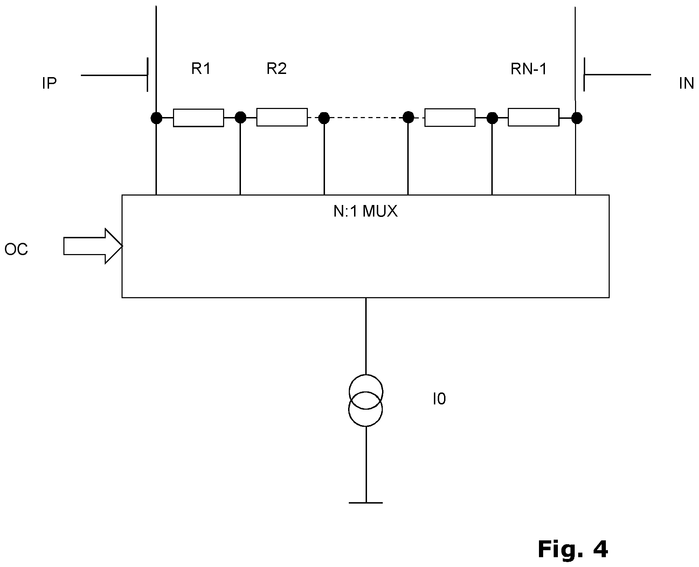

Fig. 4 zeigt die Offset-Kompensation im Transimpedanzverstärker TV.

Auf ähnliche Weise wie oben wird dann der Offset korrigiert Hierbei wird der Offset im Transimpedanzverstärker durch eine asymmetrische Einspeisung des Stroms der Stromquelle der Eingangsdifferenzstufe in dieselbe eingestellt. In der erfindungsgemäßen Vorrichtung erfolgt die Stromeinspeisung über einen 1:N Multiplexer, wobei N die Anzahl der möglichen Einspeisepositionen angibt. Die beiden Zweige der Differenzeingangsstufe sind durch eine Serienschaltung von N-1 Widerständen verbunden, die typischerweise gleichartig sind und vorzugsweise den gleichen oder einen ähnlichen Temperaturkoeffizienten wie die Widerstände der typischerweise in der Schaltung vorhandenen Spannungsreferenz aufweisen. Der N:1 Multiplexer verbindet nun die Stromquelle mit einem der sich ergebenden Verbindungspunkte zwischen den N-1 Widerständen, wobei die Außenpunkte in dieser beispielhaften Ausführung durch den Multiplexer ebenfalls als Einspeisepunkt gewählt werden können.

Die erfindungsgemäße Vorrichtung verfügt nur über wenige analoge Schaltungsteile und sehr viele digitale Schaltungsteile, was einen Vorteil darstellt. Aufgrund der Einfachheit der Schaltung benötigt diese nur eine sehr kleine Fläche in einer monolithisch integrierten Schaltung. Daher ist es möglich, für jedes Thermopile-Pixel einer Zeile einen derartigen Delta-Sigma-Wandler vorzusehen und nur zeilenweise umzuschalten. Jede Spalte eines Thermopile-Arrays ist daher bevorzugt einem Delta-Sigma-Wandler zugeordnet. Ein 32x32 Thermopile-Pixelarray würde dann also über 32 erfindungsgemäße Delta-Sigma-Wandler verfügen, von denen jeder über je einen 32:1 Analogmultiplexer AMUX mit genau einem Thermopile-Pixel in einer Thermopile-Pixelzeile, die gerade in Bearbeitung ist, verbunden wird. Schaltet der Analogmultiplexer AMUX von einer Zeile in die nächste, so toggelt auch das langsame Chopper-Signal A.

Der 6-Bit-Digital-zu-Analog-Konverter DAC wird dabei beispielsweise so realisiert, dass in eine Widerstandkaskade mit 63 gleichen Widerständen ein Strom eingeprägt wird und die jeweilige Spannung über einen 64:1 Multiplexer als Rückkoppelsignal S8 ausgewählt wird. Dies hat den Vorteil, dass alle 32 den 32 Spalten eines beispielhaften 32x32 Thermopile-Arrays zugeordneten Delta-Sigma-Wandler die gleiche Widerstandskette aus 63 gleichen Widerständen nutzen können, was das Matching von Pixel zu Pixel erheblich verbessert.

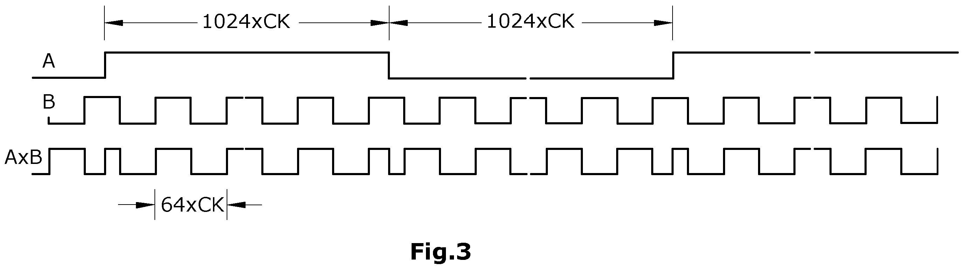

Fig. 3 zeigt ein Taktschema bezogen auf den digitalen Systemtakt CK für das schnelle Chopper-Signal B und das langsame Chopper-Signal A. Wichtig ist, dass die Flanken des langsamen Chopper-Signals A und des schnellen Chopper-Signals B sich nach Möglichkeit nicht überlappen sollten. Eine Überlappung der Flanken würde zu Störungen führen. Daher werden die Flanken des langsamen Chopper-Signals A vorzugsweise in der Puls-Mitte eines Pulses des schnellen Chopper-Signals B positioniert. Die zweite Frequenz des langsamen Chopper-Signals B ist dabei vorzugsweise um mindestens den Faktor 2 höher als die erste Frequenz das langsamen Chopper-Signals A. Die zweite Frequenz des schnellen Chopper-Signals B sollte ein gradzahliges Vielfaches der ersten Frequenz des langsamen Chopper-Signals A betragen.

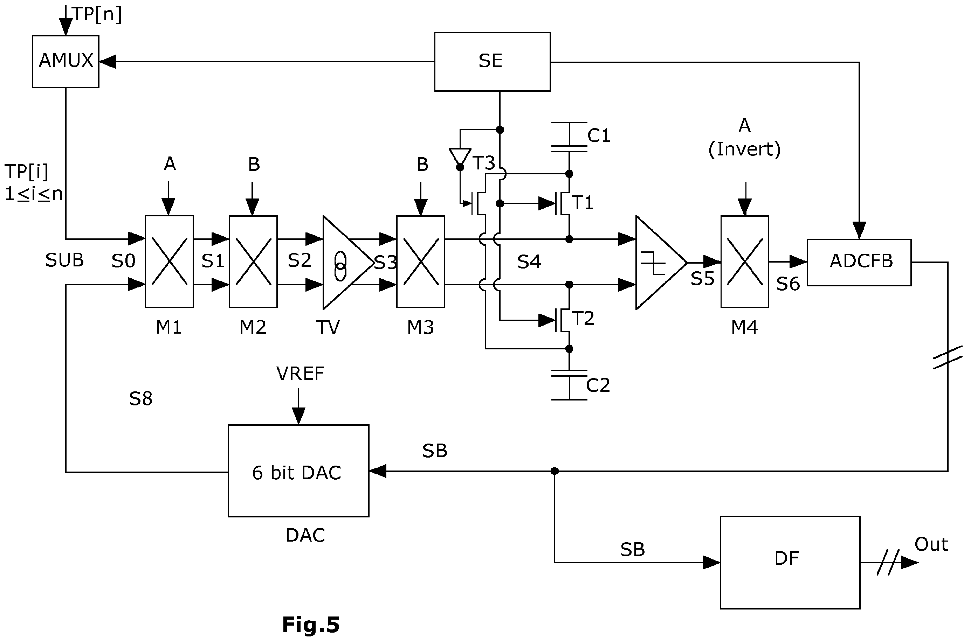

In Fig. 5 ist ein alternatives Verschaltungsschema des erfindungsgemäßen Delta-Sigma-Wandlers gezeigt, wobei die gleichen Bezugszeichen verwendet sind wie in Fig. 1. Der Unterschied der Fign. 1 und 5 besteht in der Entladungsschaltung für die Kondensatoren C1 und C2 des Tiefpassfilters. Im Ausführungsbeispiel gemäß Fig. 5 werden die beiden Kondensatoren nicht gänzlich entladen, wenn mit dem Auslesen des nächsten Thermopile-Pixels begonnen wird. Vielmehr erfolgt im Ausführungsbeispiel nach Fig. 5 ein Ausgleich einer potentiellen Ladungsdifferenz zwischen den beiden Kondensatoren C1 und C2. Zu diesem Zweck werden die Kondensatoren C1, C2 durch Ansteuerung der beiden Transistoren T1 und T2 von den Signalleitungen entkoppelt und in diesem Zustand über einen Transistoren T3 miteinander verbunden, so dass der Ladungsausgleich stattfinden kann. Anschließend wird der Transistor T3 gesperrt und die beiden Transistoren T1 und T2 in den leitenden Zustand überführt, so dass beide Kondensatoren C1 und C2 zu Beginn des nächsten Ausleseintervalls die gleiche elektrische Ladung führen.

Im Übrigen arbeitet die Schaltung nach Fig. 5 genauso wie die Schaltung nach Fig. 1.

Im Vorhergehenden wurde die Erfindung beschrieben anhand des Auslesens eines Thermopile-Pixel-Array. Selbstverständlich ist die Erfindung hinsichtlich der Abfolge des Auslesens unterschiedlicher analoger Signale und deren Umsetzung in digitale Signale nicht auf das Auslesen mehrerer Pixel eines Array beschränkt. Genauso ist es erfindungsgemäß möglich, ein und dasselbe Pixel bzw. ein und denselben Detektor sukzessive zeitlich hintereinander in einzelnen Ausleseintervallen auszulesen, um das analoge Auslesesignal, wie zuvor beschrieben, in ein Digitalsignal zu wandeln. Die Erfindung ist selbstverständlich nicht auf Pixel-Arrays beschränkt. Entscheidend für die Erfindung ist vielmehr, dass dem Wandler sukzessive in zeitlich hintereinanderliegenden Ausleseintervallen Analogsignale (seien es Spannungs- oder Stromsignale) zugeführt werden. Ob diese Analogsignale letztendlich von ein und demselben Pixel oder aber sukzessive von den Pixeln eines Arrays stammen, spielt für die Erfindung keine Rolle.

Außerdem sei darauf hingewiesen, dass die Erfindung nicht auf die Anwendung bei einem Thermopile beschränkt ist. Auch andere IR-Strahlungs-Detektoren wie beispielsweise Bolometer, PIR etc. sind denkbar. Es spielt für die Erfindung auch keine Rolle, ob diese IR-Strahlungs-Detektoren analoge Strom- oder Spannungssignale liefern. Ferner ist es möglich, dass der IR-StrahlungsDetektor mit Betriebsenergie zu versorgen ist, um ein Analog-Signal an seinem Ausgang zu liefern, das die empfangene IR-Strahlung repräsentiert. Insoweit können also IR-Strahlungs-Detektoren eingesetzt werden, die ohne Zufuhr elektrischer Energie ein Ausganssignal liefern, wie dies beispielsweise bei PIR und bei Thermopile der Fall ist.

### BEZUGSZEICHENLISTE

- A: langsames Chopper-Signal. Bei jedem Wechsel der Thermopile Zeile beginnt ein neuer Zyklus des langsamen Chopper-Signals (auch erstes Chopper-Signal genannt). Es handelt sich daher vorzugsweise um ein digitales Signal.
- ADCFB: Digitaler Integrator mit Filter zur Stabilisierung des Regelkreises
- AMUX: Multiplexer zur Zeilenumschaltung bei dem Auslesen eines Thermopile-Pixelarrays
- B: schnelles Chopper-Signal. Das schnelle Chopper-Signal B hat typischerweise eine höhere zweite Frequenz als das langsame ChopperSignal A. Vorzugsweise ist seine zweite Frequenz zum einen geradzahligen Faktor gegenüber der ersten Frequenz des langsamen Chopper-Signals A erhöht. Es handelt sich typischerweise um ein digitales Signal.
- C1: erste Hälfte der differentielle Integrationskapazität bestehend aus der ersten Einzelkapazität
- C2: zweite Hälfte der differentielle Integrationskapazität bestehend aus der zweiten Einzelkapazität
- CK: Systemtakt
- CMP: Komparator/Quanisierer
- DAC: Digital-zu-Analog-Wandler
- DF: digitales Ausgangsfilter
- M1: erster Multiplizierer. Durch das langsame Chopper-Signal A digital angesteuerter Doppelumschalter, der die Ausgänge bei einem Wechsel des logischen Werts des langsamen Chopper-Signals A vertauscht.
- M2: zweiter Multiplizierer. Der zweite Multiplizierer wird typischerweise als digital durch das schnelle Chopper-Signal B angesteuerter Doppelumschalter realisiert, der die Ausgänge bei einem Wechsel des logischen Werts des Chopper-Signals B vertauscht.
- M3: dritter Multiplizierer. Der dritte Multiplizierer wird typischerweise als digital durch das schnelle Chopper-Signal B angesteuerter Doppelumschalter realisiert, der die Ausgänge bei einem Wechsel des logischen Werts des schnellen Chopper-Signals B vertauscht.
- M4: vierter Multiplizierer. Der vierte Multiplizierer wird typischerweise als digital durch das invertierte langsame Chopper-Signal A angesteuertes EXOR-Gatter realisiert, das das fünfte Signal (S5) in Abhängigkeit vom langsamen Chopper-Signal A invertiert oder nicht invertiert, was einer Multiplikation mit 1 oder -1 gleichkommt, wenn die logischen Pegel 1 und -1 entsprechen sollen.
- Out: Ausgangssignal
- TP[n]: Das Spannungssignal TP[n] des n-ten Pixels, das an den erfindungsgemäßen Delta-Sigma-Wandler für die Auswertung eines Thermopile-Arrays angelegt wird.
- S0: (differentielles) Eingangssignal
- S1: erstes (differentielles) Signal
- S2: zweites (differentielles) Signal
- S3: drittes (differentielles) Signal
- S4: viertes (differentielles) Signal
- S5: fünftes Signal (nicht differentiell)
- S6: sechstes Signal (nicht differentiell)
- SB: siebtes Signal (digitaler 6-Bit-Datenbus mit den Bitsignalen SB[0], SB[1], SB[2], SB[3], SB[4], SB[5])
- S8: Rückkoppelsignal
- SAR: beispielhaftes internes Signal zur Markierung des Modus, in dem der Arbeitspunkt durch sukzessive Approximation durch das Filter ADCFB gesucht wird.
- SE: Steuereinheit
- T1: Entladungs- bzw. Entkopplungstransistor
- T2: Entladungs- bzw. Entkopplungstransistor
- T3: Ladungsausgleichstransistor
- TV: Transimpedanzverstärker

## Patentansprüche

1. Verfahren zur Wandlung eines Analog-Signals (TP[i]), wie z.B. eines Spannungs-Auslesesignals eines Thermopile-Pixels oder eines Pixels eines anderen strahlungsempfindlichen Detektors, in ein Mehrbit-Digital-Signal (SB), mit den folgenden Schritten:
- sukzessives Zuführen von Analog-Signalen (TP[i]) unterschiedlicher Größe zum Eingang eines Delta-Sigma-Wandlers für die Dauer von jeweiligen Ausleseintervallen, innerhalb derer die Analog-Signale (TP[i]) im Wesentlichen jeweils unverändert bleiben,
- Bilden eines einem Analog-Signal entsprechenden Mehrbit-Digital-Signals (SB) durch den Delta-Sigma-Wandler mit einem Ein-Bit-Analog-Digital-Wandler in Form eines Quantisierers (CMP) und einem in Reihe mit diesem geschalteten Regler (ADCFB), an dessen Ausgang das Mehrbit-Digital-Signal (SB) ansteht,
- Umwandeln des Mehrbit-Digital-Signals durch einen Mehrbit-Digital-Analog-Wandler (DAC) in ein analoges Rückführsignal (S8),
- Bilden eines Differenzsignals (S0) aus dem Analog-Signal (TP[i]) und dem analogen Rückführsignal (S8),
- Multiplizieren dieses Differenzsignals (S0) mit einem eine erste Frequenz aufweisenden ersten Chopper-Signal (A) zur Bildung eines ersten Differenzsignals (S1),
- Multiplizieren dieses ersten Differenzsignals (S1) mit einem eine zweite Frequenz aufweisenden zweiten Chopper-Signal (B) zur Bildung eines zweiten Differenzsignals (S2), wobei die zweite Frequenz größer ist als die erste Frequenz,
- Verstärken dieses zweiten Differenzsignals (S2) zur Bildung eines dritten Differenzsignals (S3),
- Multiplizieren dieses dritten Differenzsignals (S3) mit dem zweiten Chopper-Signal (B) zur Bildung eines vierten Differenzsignals (S4),
- Tiefpassfiltern dieses vierten Differenzsignals (S4) mittels eines Tiefpassfilters (C1,C2) und Zuführen des tiefpassgefilterten vierten Differenzsignals (S4) zum Eingang des Quantisierers;-Ausgeben eines fünften Differenzsignals (S5) durch den Quantisierer;
- Multiplizieren dieses fünften Differenzsignals (S5) mit einem invertierten ersten Chopper-Signal (A) zur Bildung eines sechsten Digital-Signals (S6),
- Zuführen dieses sechsten Digital-Signals (S6) zum Regler (ADCFB) zur Bildung des Mehrbit-Digital-Signals; und
- Ausgeben des Mehrbit-Digital-Signals (SB) gegebenenfalls nach einer Digitalfilterung (DF),
- wobei der Regler (ADCFB) wahlweise in einem ersten Modus und in einem zweiten Modus betrieben wird,
- wobei der Regler (ADCFB) Sollwert/Istwert-Abweichungen zwischen dem Analog-Signal (TP[i]) und dem analogen Rückführsignal (S8) in seinem ersten Betriebsmodus schneller ausregelt als in seinem zweiten Betriebsmodus,
- wobei der Regler (ADCFB) in einer Anfangsphase des Ausleseintervalls zwecks möglichst schneller Nachführung des Digital-Mehrbit-Signals (SB) zum Analog-Signal in seinem ersten Betriebsmodus betrieben wird und
- wobei der Regler (ADCFB) nach dieser Anfangsphase des Ausleseintervalls und für dessen restliche Dauer in seinem zweiten Betriebsmodus betrieben wird.

2. Verfahren nach Anspruch 1, **dadurch gekennzeichnet, dass** das Tiefpassfilter (C1,C2) mindestens einen Kondensator aufweist, der nach dem Ende eines Ausleseintervalls und/oder zu Beginn der Anfangsphase des nächsten Ausleseintervalls entladen wird.

3. Verfahren nach Anspruch 1, **dadurch gekennzeichnet, dass** das Tiefpassfilter (C1,C2) zwei mit jeweils einem anderen seiner Eingänge gekoppelte Kondensatoren aufweist und dass nach dem Ende eines Ausleseintervalls und/oder zu Beginn der Anfangsphase des nächsten Ausleseintervalls ein potentieller Ladungsunterschied zwischen den Kondensatoren ausgeglichen oder entfernt wird.

4. Verfahren nach einem der Ansprüche 1 bis 3, **dadurch gekennzeichnet, dass** ein Thermopile-Pixelarray bereitgestellt wird, das mehrere Zeilen von Pixeln mit jeweils mehreren Pixeln aufweist, und dass pro Zeile deren jeweilige Pixel-Auslesesignale gleichzeitig ausgelesen werden, und zwar jeweils gemäß den Verfahrensschritten nach einem der vorhergehenden Ansprüche, und dass sukzessive von Zeile zu Zeile umgeschaltet wird, um das Thermopile-Pixelarray auszulesen.

5. Vorrichtung zur Wandlung eines Analog-Signals (TP[i]), wie z.B. eines Spannungs-Auslesesignals eines Thermopile-Pixels oder eines Pixels eines anderen strahlungsempfindlichen Detektors, in ein Mehrbit-Digital-Signal (SB), mit
- einem Delta-Sigma-Wandler, dessen Eingang für die Dauer von jeweiligen Ausleseintervallen, innerhalb derer die Analog-Signale (TP[i]) im Wesentlichen jeweils unverändert bleiben, Analog-Signale (TP[i]) unterschiedlicher Größe zuführbar sind,
- wobei der Delta-Sigma-Wandler zum Bilden eines einem Analog-Signal entsprechenden Mehrbit-Digital-Signals (SB) einen Ein-Bit-Analog-Digital-Wandler in Form eines Quantisierers (CMP) und einen in Reihe mit diesem geschalteten Regler (ADCFB) aufweist, an dessen Ausgang das Mehrbit-Digital-Signals (SB) ausgebbar ist,
- einem Mehrbit-Digital-Analog-Wandler (DAC) zur Wandlung des Mehrbit-Reglersignals in ein analoges Rückführsignal (S8),
- einer Subtraktionseinheit (M1) zum Bilden eines Differenzsignals (S0) aus dem Analog-Signal (TP[i]) und dem analogen Rückführsignal (S8),
- einem Multiplizierer (M1) zum Multiplizieren dieses Differenzsignals (S0) mit einem eine erste Frequenz aufweisenden ersten Chopper-Signal (A) zur Bildung eines ersten Differenzsignals (S1),
- einem Multiplizierer (M2) zum Multiplizieren dieses ersten Differenzsignals (S1) mit einem eine zweite Frequenz aufweisenden zweiten Chopper-Signal (B) zur Bildung eines zweiten Differenzsignals (S2), wobei die zweite Frequenz größer ist als die erste Frequenz,
- einem Verstärker (TV) zum Verstärken dieses zweiten Differenzsignals (S2) zur Bildung eines dritten Differenzsignals (S3),
- einem Multiplizierer (M3) zum Multiplizieren dieses dritten Differenzsignals (S3) mit dem zweiten Chopper-Signal (B) zur Bildung eines vierten Differenzsignals (S4),
- einem Tiefpassfilter (C1,C2) zum Tiefpassfiltern dieses vierten Differenzsignals (S4) und zum Zuführen des tiefpassgefilterten vierten Differenzsignals (S4) zum Eingang des Quantisierers wobei der Quantisierer zum Ausgeben eines fünften Differenzsignals (S5) ausgebildet ist,
- einem Multiplizierer (M4) zum Multiplizieren dieses fünften Differenzsignals (S5) mit einem invertierten ersten Chopper-Signal (A) zur Bildung eines sechsten Digital-Signals (S6), das dem Regler (ADCFB) zur Bildung des Mehrbit-Digital-Signals (SB) zuführbar ist, und
- einer Ansteuereinheit (SE) zur Ansteuerung zumindest des Reglers (ADCFB),
- wobei der Regler (ADCFB) wahlweise in einem ersten Modus und in einem zweiten Modus betreibbar ist,
- wobei Sollwert/Istwert-Abweichungen zwischen dem Analog-Signal (TP[i]) und dem analogen Rückführsignal (S8) in dem ersten Betriebsmodus des Reglers (ADCFB) schneller ausregelbar sind als in dessen zweiten Betriebsmodus,
- wobei der Regler (ADCFB) in einer Anfangsphase des Ausleseintervalls zwecks möglichst schneller Nachführung des digitalen Mehrbit-Digital-Signals (SB) zum Analog-Signal in seinem ersten Betriebsmodus betreibbar ist und
- wobei der Regler (ADCFB) nach dieser Anfangsphase des Ausleseintervalls und für dessen restliche Dauer in seinem zweiten Betriebsmodus betreibbar ist.

6. Vorrichtung nach Anspruch 5, **dadurch gekennzeichnet, dass** das Tiefpassfilter (C1,C2) mindestens einen Kondensator aufweist, der nach dem Ende eines Ausleseintervalls und/oder zu Beginn der Anfangsphase des nächsten Ausleseintervalls entladbar ist.

7. Vorrichtung nach Anspruch 5, **dadurch gekennzeichnet, dass** das Tiefpassfilter (C1,C2) zwei mit jeweils einem anderen seiner Eingänge gekoppelte Kondensatoren aufweist und dass nach dem Ende eines Ausleseintervalls und/oder zu Beginn der Anfangsphase des nächsten Ausleseintervalls ein potentieller Ladungsunterschied zwischen den Kondensatoren ausgleichbar oder entfernbar ist.

8. Vorrichtung nach einem der Ansprüche 5 bis 7, **dadurch gekennzeichnet, dass** der Sensor mindestens eine Zeile mit mehreren Pixeln aufweist, dass die Pixel-Auslesesignale pro Zeile gleichzeitig auslesbar sind.

## Claims

1. A method for converting an analog signal (TP[i]), e.g. a voltage readout signal of a thermopile pixel or a pixel of another detector sensitive to radiation, into a multibit digital signal (SB), comprising the following steps:
- successively supplying analog signals (TP[i]) of different sizes to the input of a delta sigma converter for the duration of respective readout intervals within which the analog signals (TP[i]) each substantially remain unchanged,
- forming a multibit digital signal (SB) corresponding to an analog signal by the delta sigma converter with a one-bit analog-to-digital converter in the form of a quantizer (CMP) and a controller (ADCFB) connected in series thereto at whose output the multibit digital signal (SB) is available,
- converting the multibit digital signal by a multibit digital-to-analog-converter (DAC) into an analog feedback signal (S8),
- forming a differential signal (S0) from the analog signal (TP[i]) and the analog feedback signal (S8),
- multiplying said differential signal (S0) by a chopper signal (A) having a first frequency in order to form a first differential signal (S1),
- multiplying said first differential signal (S1) by a second chopper signal (B) having a second frequency in order to form a second differential signal (S2), the second frequency being larger than the first frequency,
- amplifying said second differential signal (S2) to form a third differential signal (S3),
- multiplying said third differential signal (S3) by the second chopper signal (B) to form a fourth differential signal (S4),
- low-pass filtering said fourth differential signal (S4) by means of a low-pass filter (C1, C2) and supplying said low-pass filtered fourth differential signal (S4) to the input of the quantizer;
- outputting a fifth differential signal (S5) by the quantizer;
- multiplying said fifth differential signal (S5) by an inverted first chopper signal (A) to form a sixth digital signal (S6),
- supplying said sixth digital signal (S6) to the controller (ADCFB) to form the multibit digital signal; and
- outputting the multibit digital signal (SB), optionally after digital filtering (DF),
- wherein the controller (ADCFB) is selectively operated in a first mode and in a second mode,
- wherein the controller (ADCFB) compensates target value/actual value deviations between the analog signal (TP[i]) and the analog feedback signal (S8) faster in its first operating mode than in its second operating mode,
- wherein the controller (ADCFB) is operated in its first operating mode in an initial phase of the readout interval for the purpose of tracking the digital multibit signal (SB) to the analog signal as quickly as possible, and
- wherein the controller (ADCFB) is operated in its second operating mode after said initial phase of the readout interval and for the remaining duration.

2. The method according to claim 1, **characterized in that** the low-pass filter (C1, C2) has at least one capacitor which is discharged after the end of a readout interval and/or at the beginning of the initial phase of the second readout interval.

3. The method according to claim 1, **characterized in that** the low-pass filter (C1, C2) has two capacitors, each coupled with another one of its inputs, and that after the end of a readout interval and/or at the beginning of the initial phase of the next readout interval a potential load difference between the capacitors is balanced or removed.

4. The method according to any one of claims 1 to 3, **characterized in that** a thermopile pixel array is provided, comprising a plurality of rows of pixels each having a plurality of pixels, and **in that** per row their respective pixel readout signals are read out simultaneously, each according to the method steps according to one of the preceding claims, and **in that** successive switching is performed from row to row to read out the thermopile pixel array.

5. A device for converting an analog signal (TP[i]), e.g. a voltage readout signal of a thermopile pixel or a pixel of another detector sensitive to radiation, into a multibit digital signal (SB), comprising
- a delta sigma converter to whose input analog signals (TP[i]) of different sizes can be supplied for the duration of respective readout intervals within which the analog signals (TP[i]) each substantially remain unchanged,
- wherein the delta sigma converter has a one-bit analog-to-digital-converter in the form of a quantizer (CMP) and a controller (ADCFB) connected in series thereto at whose output the multibit digital signal (SB) can be output, in order to form a multibit digital signal (SB) corresponding to an analog signal,
- a multibit digital-to-analog-converter (DAC) for converting the multibit controller signal into an analog feedback signal (S8),
- a subtraction unit (M1) for forming a differential signal (S0) from the analog signal (TP[i]) and the analog feedback signal (S8),
- a multiplier (M1) for multiplying said differential signal (S0) by a first chopper signal (A) having a first frequency in order to form a first differential signal (S1),
- a multiplier (M2) for multiplying said first differential signal (S1) by a second chopper signal (B) having a second frequency in order to form a second differential signal (S2), the second frequency being larger than the first frequency,
- an amplifier (TV) for amplifying said second differential signal (S2) in order to form a third differential signal (S3),
- a multiplier (M3) for multiplying said third differential signal (S3) by the second chopper signal (B) in order to form a fourth differential signal (S4),
- a low-pass filter (C1, C2) for low-pass filtering said fourth differential signal (S4) and for supplying the low-pass filtered fourth differential signal (S4) to the input of the quantizer, the quantizer being configured to output a fifth differential signal (S5),
- a multiplier (M4) for multiplying said fifth differential signal (S5) by an inverted first chopper signal (A) in order to form a sixth digital signal (S6) which can be supplied to the controller (ADCFB) in order to form the multibit digital signal (SB), and
- a control unit (SE) for controlling at least the controller (ADCFB),
- wherein the controller (ADCFB) is selectively operated in a first mode and in a second mode,
- wherein the controller (ADCFB) compensates target value/actual value deviations between the analog signal (TP[i]) and the analog feedback signal (S8) faster in its first operating mode than in its second operating mode,
- wherein the controller (ADCFB) is operated in its first operating mode in an initial phase of the readout interval for the purpose of tracking the digital multibit signal (SB) to the analog signal as quickly as possible, and
- wherein the controller (ADCFB) is operated in its second operating mode after said initial phase of the readout interval and for the remaining duration.

6. The device according to claim 5, **characterized in that** the low-pass filter (C1, C2) has at least one capacitor which can be discharged after the end of a readout interval and/or at the beginning of the initial phase of the second readout interval.

7. The device according to claim 5, **characterized in that** the low-pass filter (C1, C2) has two capacitors, each coupled with another one of its inputs, and that after the end of a readout interval and/or at the beginning of the initial phase of the next readout interval a potential load difference between the capacitors is balanced or removed.

8. The device according to any one of claims 5 to 7, **characterized in that** the sensor has at least one row of a plurality of pixels, that the pixel readout signals per row can be read out simultaneously.

## Revendications

1. Procédé de conversion d'un signal analogique (TP[i]), comme par exemple un signal de lecture en tension d'un pixel thermopile ou d'un pixel d'un autre détecteur sensible au rayonnement, en un signal numérique multi-bits (SB), avec les étapes suivantes :
- délivrance successive de signaux analogiques (TP[i]) de grandeurs différentes à l'entrée d'un convertisseur Delta-Sigma pour la durée d'intervalles de lecture respectifs, à l'intérieur desquels les signaux analogiques respectifs (TP[i]) restent sensiblement inchangés,
- création d'un signal numérique multi-bits (SB) correspondant à un signal analogique par le convertisseur Delta-Sigma avec un convertisseur analogique-numérique 1 bit sous forme d'un quantificateur (CMP) et avec un régulateur (ADCFB) commuté en série avec celui-ci, à la sortie duquel le signal numérique multi-bits (SB) est présent,
- conversion du signal numérique multi-bits par un convertisseur numérique-analogique multi-bits (DAC) en un signal de rétroaction analogique (S8),
- création d'un signal différentiel (S0) à partir du signal analogique (TP[i]) et du signal de rétroaction analogique (S8),
- multiplication de ce signal différentiel (S0) par un premier signal de hachage (A) comportant une première fréquence afin de créer un premier signal différentiel (S1),
- multiplication de ce premier signal différentiel (S1) par un deuxième signal de hachage (B) comportant une deuxième fréquence pour créer un deuxième signal différentiel (S2), dans lequel la deuxième fréquence est supérieure à la première fréquence,
- amplification de ce deuxième signal différentiel (S2) afin de créer un troisième signal différentiel (S3),
- multiplication de ce troisième signal différentiel (S3) par le deuxième signal de hachage (B) afin de créer un quatrième signal différentiel (S4),
- filtrage passe-bas de ce quatrième signal différentiel (S4) au moyen d'un filtre passe-bas (C1, C2) et délivrance du quatrième signal différentiel (S4) filtré passe-bas à l'entrée du quantificateur ;
- émission d'un cinquième signal différentiel (S5) par le quantificateur ;
- multiplication de ce cinquième signal différentiel (S5) par un premier signal de hachage inversé (A) afin de créer un sixième signal différentiel (S6),
- délivrance de ce sixième signal différentiel (S6) au régulateur (ADCFB) afin de créer le signal numérique multi-bits ; et
- émission du signal numérique multi-bits (SB) le cas échéant après un filtrage numérique (DF),
- dans lequel le régulateur (ADCFB) fonctionne sélectivement dans un premier mode et dans un deuxième mode,
- dans lequel le régulateur (ADCFB) régule les déviations valeur nominale/valeur réelle entre le signal analogique (TP[i]) et le signal de rétroaction analogique (S8) plus rapidement dans son premier mode de fonctionnement que dans son deuxième mode de fonctionnement,
- dans lequel le régulateur (ADCFB) fonctionne dans son premier mode de fonctionnement dans une phase initiale de l'intervalle de lecture pour une transformation du signal numérique multi-bits (SB) en signal analogique la plus rapide possible et
- dans lequel le régulateur (ADCFB) fonctionne dans son deuxième mode de fonctionnement après la phase initiale de l'intervalle de lecture et pour le reste de la durée de celui-ci.

2. Procédé selon la revendication 1, **caractérisé en ce que** le filtre passe-bas (C1, C2) comporte au moins un condensateur, lequel est déchargé après la fin de l'intervalle de lecture et/ou au début de la phase initiale de l'intervalle de lecture suivant.

3. Procédé selon la revendication 1, **caractérisé en ce que** le filtre passe-bas (C1, C2) comporte deux condensateurs couplés avec respectivement une autre de ses entrées et **en ce qu'**après la fin de l'intervalle de lecture et/ou au début de la phase initiale de l'intervalle de lecture suivant une différence potentielle de charge entre les condensateurs est compensée ou éliminée.

4. Procédé selon l'une des revendications 1 à 3, **caractérisé en ce qu'**un réseau de pixels thermopiles est préparé, lequel comporte plusieurs lignes de pixels respectivement dotées de plusieurs pixels, et **en ce que** les signaux de lecture des pixels de chaque ligne sont lus simultanément, à savoir respectivement selon les étapes de procédé selon l'une des revendications précédentes, et **en ce qu'**une commutation successive est effectuée de ligne en ligne afin de lire le réseau de pixels thermopiles.

5. Dispositif destiné à la conversion d'un signal analogique (TP[i]), comme par exemple un signal de lecture en tension d'un pixel thermopile ou d'un pixel d'un autre détecteur sensible au rayonnement, en un signal numérique multi-bits (SB), doté :
- d'un convertisseur Delta-Sigma, à l'entrée duquel peuvent être délivrés des signaux analogiques (TP[i]) de grandeurs différentes pour la durée d'intervalles de lecture respectifs, à l'intérieur desquels les signaux analogiques respectifs (TP[i]) restent sensiblement inchangés,
- dans lequel le convertisseur Delta-Sigma comporte, afin de créer un signal numérique multi-bits (SB) correspondant à un signal analogique, un convertisseur analogique-numérique 1 bit sous forme d'un quantificateur (CMP) et un régulateur (ADCFB) commuté en série avec celui-ci, à la sortie duquel le signal numérique multi-bits (SB) peut être émis,
- d'un convertisseur numérique-analogique multi-bits (DAC) destiné à convertir le signal de régulateur multi-bits en un signal de rétroaction analogique (S8),
- d'une unité de soustraction (M1) destinée à créer un signal différentiel (S0) à partir du signal analogique (TP[i]) et du signal de rétroaction analogique (S8),
- d'un multiplicateur (M1) destiné à la multiplication de ce signal différentiel (S0) par un premier signal de hachage (A) comportant une première fréquence afin de créer un premier signal différentiel (S1),
- d'un multiplicateur (M2) destiné à la multiplication de ce premier signal différentiel (S1) par un deuxième signal de hachage (B) comportant une deuxième fréquence pour créer un deuxième signal différentiel (S2), dans lequel la deuxième fréquence est supérieure à la première fréquence,
- d'un amplificateur (TV) destiné à amplifier ce deuxième signal différentiel (S2) afin de créer un troisième signal différentiel (S3),
- d'un multiplicateur (M3) destiné à la multiplication de ce troisième signal différentiel (S3) par le deuxième signal de hachage (B) afin de créer un quatrième signal différentiel (S4),
- d'un filtre passe-bas (C1, C2) destiné au filtrage passe-bas de ce quatrième signal différentiel (S4) et à délivrer le quatrième signal différentiel (S4) filtré passe-bas à l'entrée du quantificateur, dans lequel le quantificateur est réalisé pour l'émission d'un cinquième signal différentiel (S5),
- d'un multiplicateur (M4) destiné à la multiplication de ce cinquième signal différentiel (S5) par un premier signal de hachage inversé (A) afin de créer un sixième signal différentiel (S6), lequel peut être délivré au régulateur (ADCFB) afin de créer le signal numérique multi-bits (SB), et
- d'une unité de commande (SE) destinée à commander au moins le régulateur (ADCFB),
- dans lequel le régulateur (ADCFB) peut fonctionner sélectivement dans un premier mode et dans un deuxième mode,
- dans lequel les déviations valeur nominale/valeur réelle entre le signal analogique (TP[i]) et le signal de rétroaction analogique (S8) peuvent être régulées plus rapidement dans le premier mode de fonctionnement du régulateur (ADCFB) que dans le deuxième mode de fonctionnement de celui-ci,
- dans lequel le régulateur (ADCFB) peut fonctionner dans son premier mode de fonctionnement dans une phase initiale de l'intervalle de lecture pour une transformation du signal numérique multi-bits (SB) en signal analogique la plus rapide possible et
- dans lequel le régulateur (ADCFB) peut fonctionner dans son deuxième mode de fonctionnement après la phase initiale de l'intervalle de lecture et pour le reste de la durée de celui-ci.

6. Dispositif selon la revendication 5, **caractérisé en ce que** le filtre passe-bas (C1, C2) comporte au moins un condensateur, lequel peut être déchargé après la fin de l'intervalle de lecture et/ou au début de la phase initiale de l'intervalle de lecture suivant.

7. Dispositif selon la revendication 5, **caractérisé en ce que** le filtre passe-bas (C1, C2) comporte deux condensateurs couplés avec respectivement une autre de ses entrées et **en ce qu'**après la fin de l'intervalle de lecture et/ou au début de la phase initiale de l'intervalle de lecture suivant une différence potentielle de charge entre les condensateurs peut être compensée ou éliminée.

8. Dispositif selon l'une des revendications 5 à 7, **caractérisé en ce que** le capteur comporte au moins une ligne dotée de plusieurs pixels, **en ce que** les signaux de lecture des pixels peuvent être lus simultanément par ligne.
